# EUROPEAN PATENT SPECIFICATION

(11) **EP 3 331 039 B1**
(45) Date of publication and mention of the grant of the patent: **30.12.2020**
(21) Application number: 17202263.4
(22) Date of filing: 17.11.2017
(51) Int. Cl.: H01L 51/00, H01L 51/52

(54) **LIGHTING APPARATUS USING ORGANIC LIGHT-EMITTING DIODE AND METHOD OF FABRICATING THE SAME**
BELEUCHTUNGSVORRICHTUNG MIT VERWENDUNG VON ORGANISCHER LEUCHTDIODE UND VERFAHREN ZUR HERSTELLUNG DAVON
APPAREIL D'ÉCLAIRAGE UTILISANT UNE DIODE ÉLECTROLUMINESCENTE ORGANIQUE ET SON PROCÉDÉ DE FABRICATION

(30) Priority: 30.11.2016 KR 20160162017
(43) Date of publication of application: 06.06.2018
(73) Proprietor: LG Display Co., Ltd., Seoul, 07336 (KR)
(72) Inventor: LEE, ShinBok, Paju-si, Gyeonggi-do 10845 (KR); SONG, TaeJoon, Paju-si, Gyeonggi-do 10845 (KR); KIM, NamKook, Paju-si, Gyeonggi-do 10845 (KR); YOO, SoonSung, Paju-si, Gyeonggi-do 10845 (KR); LEE, HwanKeon, Paju-si, Gyeonggi-do 10845 (KR)
(74) Representative: Viering, Jentschura & Partner mbB Patent- und Rechtsanwälte

(56) References cited:
- WO-A1-2015/049854
- US-A1- 2012 161 616
- US-A1- 2013 285 037

## Description

### BACKGROUND

### Field of the Disclosure

The present disclosure relates to a lighting apparatus, and more particularly, to a lighting apparatus using an organic light-emitting diode and a method of fabricating the same. Although the present disclosure is suitable for a wide scope of applications, it is particularly suitable for a lighting apparatus using an organic light-emitting diode, which allows for a simplified fabrication process by patterning the organic light-emitting diode without using an open mask, and a method of fabricating the same.

### Description of the Background

Common lighting apparatuses currently being used include fluorescent lamps and incandescent lamps. The incandescent lamps have good color rendering index (CRI) but very low energy efficiency, and the fluorescent lamps have good efficiency but low color rendering index and contain mercury, posing environmental concerns.

A color rendering index, which indicates how accurately colors are reproduced, is a measure of the ability of a light source to reveal the color of an object faithfully in comparison with a reference light source. The CRI of sunlight is 100.

To resolve the problems with the conventional lighting apparatuses, light-emitting diodes (LEDs) are being proposed these days. However, the LEDs are made from inorganic emissive materials and have the highest luminous efficiency at blue wavelengths, and their luminous efficiency decreases towards red wavelengths and green wavelengths, which is where the eye is most sensitive. Thus, when a red LED, a green LED, and a blue LED combine to emit white light, the luminous efficiency is low.

Lighting apparatuses using an organic light-emitting diode (OLED) are being developed as another alternative. A typical lighting apparatus using an OLED has an anode made of ITO over a glass substrate. Then, an organic emissive layer and a cathode are formed, and a passivation layer and a laminate film are attached on top of them.

The deposition process of the organic emissive layer and the electrodes, which is the core process, is usually performed in high vacuum atmosphere, so it requires as many deposition chambers for maintaining high vacuum as there are thin films to be deposited.

In recent years, the use of flexible substrates instead of glass substrates is actively under research and development. In this case, a flexible substrate, usually wound on a roll, is installed on equipment - that is, roll-to-roll equipment for continuous feeding and deposition. However, this causes to increase in the total number of processes; especially, in the OLED process after the formation of the anode, the organic emissive layer, cathode, and passivation layer are deposited using different open masks (i.e., metal masks) for the different layers. After the deposition using open masks, a cleaning process is needed at every step, and the substrate and the open masks should be aligned with each other. A misalignment may in create shadow and pattern tolerance, leading to defects. The document US 2012/161616 A1 describes a device including a first conductive electrode layer formed on a light-transmissive substrate, and a laminated layer containing a plurality of organic-compound layers formed so as to cover at least a part of the first electrode layer. The laminated layer is partly removed so that the first electrode layer is partly exposed. At least one layer containing a second conductive electrode layer is formed on the laminated layer and the exposed part of the first electrode layer. A part of the laminated layer and a part of the second electrode layer are simultaneously removed by application of a laser beam from a side of the substrate, so that a plurality of light-emitting sections are electrically connected in series on the substrate. The document US 2013/285037 A1 describes an organic EL light emitting element including a transparent conductive layer, organic light emitting unit layer, and metal layer in that order on a transparent substrate. The metal layer is divided into negative electrode regions and auxiliary electrode regions that are electrically separated by a metal layer dividing channel.

### SUMMARY OF THE DISCLOSURE

The present disclosure is directed to solving the above-described problems, and an aspect of the present disclosure is to provide a lighting apparatus using an organic light-emitting diode, which allows for depositing an organic light-emitting diode without using an open mask, and a method of fabricating the same.

These and other aspects and features of the present disclosure will become better understood with reference to the appended claims.

The present disclosure provides a lighting apparatus using an organic light-emitting diode, as defined in claim 1, and a method of fabricating a lighting apparatus using an organic light-emitting diode, as defined in claim 9. Further embodiments are described in the dependent claims.

Various embodiments provide a lighting apparatus using an organic light-emitting diode, comprising: a substrate having a lighting area, first and second peripheral areas, and first and second contact areas; a first electrode on the substrate; a first passivation layer on the first electrode; a trench in the peripheral areas; an organic emissive layer, a second electrode, and a second passivation layer on the entire surface of the substrate including the first passivation layer, except for an area of the trench, at least a portion of the first contact area and at least a portion of the second contact area; the trench being all around the outer perimeter of the lighting area and separating the organic emissive layer in the lighting area from the organic emissive layer outside the lighting area; an adhesive on the second passivation layer including an inside of the trench; and a metal film on the adhesive in the lighting area and the first and second peripheral areas.

In one or more embodiments, the first electrode is disposed at the lighting area, first and second peripheral areas, and the first contact area.

In one or more embodiments, the first passivation layer is disposed at the lighting area and the first and second peripheral areas where the first electrode and the second contact area are formed.

In one or more embodiments, a portion of the first passivation layer is exposed by the trench.

In one or more embodiments, the adhesive layer is disposed in the trench.

In one or more embodiments, the trench has a rectangular shape along an outer perimeter of the lighting area, in the peripheral areas of the substrate.

In one or more embodiments, the lighting apparatus further comprises first and second contact electrodes placed at the first and second contact areas of the substrate and electrically connected to the first and second electrodes, respectively.

In one or more embodiments, the second contact area of the substrate is positioned at the second peripheral area of the substrate, and exposes the second contact electrode to an outside of the apparatus.

In one or more embodiments, the organic emissive layer, the second electrode, and the second passivation layer are exposed at an outermost side area of the substrate.

Various embodiments provide a method of fabricating a lighting apparatus using an organic light-emitting diode, the method including: forming a first electrode on a substrate having a lighting area, first and second peripheral areas, and first and second contact areas; forming a first passivation layer on the substrate where the first electrode is formed; forming an organic emissive layer, a second electrode, and a second passivation layer on the entire surface of the substrate including the first passivation layer; forming a trench in the peripheral areas all around the outer perimeter of the lighting area by removing the organic emissive layer, the second electrode, and the second passivation layer from the first and second peripheral areas, the trench separating the organic emissive layer in the lighting area from the organic emissive layer outside the lighting area; and attaching a metal film on the second passivation layer in the lighting area and the first and second peripheral areas, with an adhesive in between.

In one or more embodiments, the first electrode is formed in the lighting area, the first and second peripheral areas, and the first contact area of the substrate.

In one or more embodiments, the first passivation layer is formed in the lighting area and the first and the second peripheral areas of the substrate where the first electrode and the second contact area of the substrate are formed.

In one or more embodiments, the trench exposes a portion of the first passivation layer by removing portions of the organic emissive layer, the second electrode, and the second passivation layer from the first and second peripheral areas of the substrate through laser ablation.

In one or more embodiments, the adhesive layer is disposed in the trench that is formed by removing the portions of the organic emissive layer, the second electrode, and the second passivation layer.

In one or more embodiments, the method further comprises, when forming the trench, simultaneously forming first and second contact holes exposing the first electrode and the first passivation layer by removing the organic emissive layer, the second electrode, and the second passivation layer from the first and second contact areas of the substrate.

In one or more embodiments, the method further comprises forming first and second contact electrodes in the first and second contact areas of the substrate, the first and second contact electrodes being electrically connected to the first and second electrodes via the first and second contact holes after the forming first and second contact holes.

As described above, the lighting apparatus using an organic light-emitting diode and the method of fabricating the same according to an exemplary aspect of the present disclosure may simplify the fabrication process of the lighting apparatus without using an open mask (metal mask), which is a complicated tool. Accordingly, it is possible to reduce costs and simplify the processes and equipment, making them adaptable to a variety of models without additional cost.

Moreover, the lighting apparatus using an organic light-emitting diode and the method of fabricating the same according to an exemplary aspect of the present disclosure allow for patterning organic light-emitting diodes by using simple equipment, without using an open mask and other tools, making them useful for roll-to-roll manufacturing.

### BRIEF DESCRIPTION OF THE DRAWINGS

The accompanying drawings, which are included to provide a further understanding of the disclosure and are incorporated in and constitute a part of this specification, illustrate exemplary aspects and together with the description serve to explain the principles of the disclosure.

In the drawings:
FIG. 1 is a cross-sectional view exemplifying a lighting apparatus using an organic light-emitting diode according to an exemplary aspect of the present disclosure;
FIG. 2 is a plan view schematically showing a lighting apparatus using an organic light-emitting diode according to an exemplary aspect of the present disclosure;
FIG. 3 is a cross-sectional view of the lighting apparatus using an organic light-emitting diode according to an exemplary aspect of the present disclosure, taken along line II-II' of FIG. 2;
FIG. 4 is a cross-sectional view exemplifying the concept of roll-to-roll equipment;
FIG. 5 is a flowchart sequentially showing a method of fabricating a lighting apparatus using an organic light-emitting diode according to an exemplary aspect of the present disclosure;
FIG. 6 is a flowchart sequentially showing a method of fabricating a lighting apparatus using an organic light-emitting diode according to a comparative example;
FIGs. 7A to 7E are plan views sequentially showing a method of fabricating the lighting apparatus using an organic light-emitting diode, shown in FIG. 2, according to an exemplary aspect of the present disclosure;
FIG. 8 is an enlarged view of the portion A of FIG. 7B; and
FIGs. 9A to 9E are cross-sectional views sequentially showing a method of fabricating the lighting apparatus using an organic light-emitting diode, shown in FIG. 3, according to an exemplary aspect of the present disclosure.

### DETAILED DESCRIPTION OF THE DISCLOSURE

Hereinafter, a lighting apparatus using an organic light-emitting diode and a method of fabricating the same according to a preferred aspect of the present disclosure will be described in sufficient detail to enable a person of ordinary skill in the art to readily practice the disclosure.

Advantages and features of the present disclosure and methods of accomplishing the same may be understood more readily by reference to the following detailed description of preferred aspects and the accompanying drawings. The present disclosure may, however, be embodied in many different forms and should not be construed as being limited to the aspects set forth herein. Rather, these aspects are provided so that this disclosure will be thorough and complete and will fully convey the concept of the disclosure to those skilled in the art, and the present disclosure will only be defined by the appended claims. Like numbers refer to like elements throughout the specification. In the drawings, the sizes and relative sizes of layers and regions may be exaggerated for clarity.

It will be understood that when an element or a layer is referred to as being "on" or "above" another element or layer, it can be directly on or above the other element or layer or intervening elements or layers may be present. In contrast, when an element or a layer is referred to as being "directly on" or "directly above" another element or layer, there are no intervening elements or layers present.

Spatially relative terms, such as "below", "beneath", "lower", "above", "upper", and the like, may be used herein for ease of description to describe one element or feature's relationship to another element(s) or feature(s) as illustrated in the figures. It will be understood that the spatially relative terms are intended to encompass different orientations of the device in use or operation, in addition to the orientation depicted in the figures. For example, if an element illustrated in the drawings is turned over, the element described to be "below" or "beneath" another element may be put "above" the other element. Accordingly, the exemplary wording "below" may include both directions corresponding to "below" and "above".

The terms used in the present specification are used to describe example aspects of inventive concepts, and not to limit the inventive concepts. A singular form may include a plural form, unless otherwise defined. The terms "comprise" and/or "comprising" specify the existence of mentioned components, steps, operations and/or elements thereof, and do not exclude the existence or addition of one or more components, steps, operations and/or elements thereof.

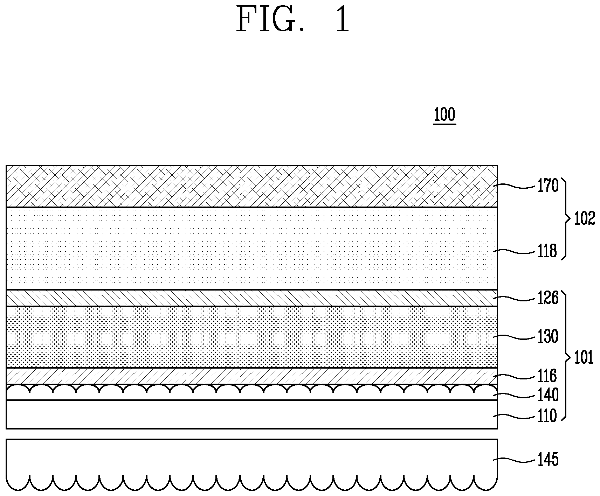

FIG. 1 is a cross-sectional view exemplifying a lighting apparatus using an organic light-emitting diode according to an exemplary aspect of the present disclosure.

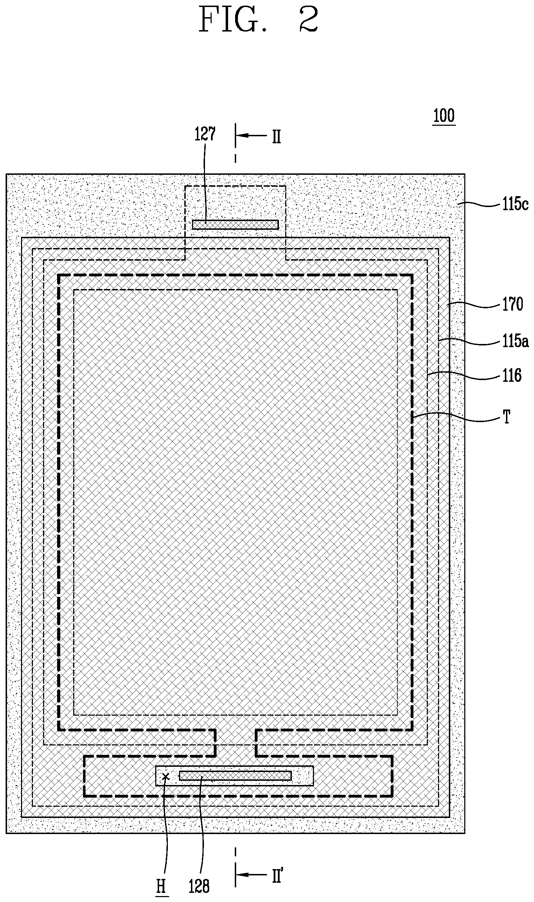

FIG. 2 is a plan view schematically showing a lighting apparatus using an organic light-emitting diode according to an exemplary aspect of the present disclosure.

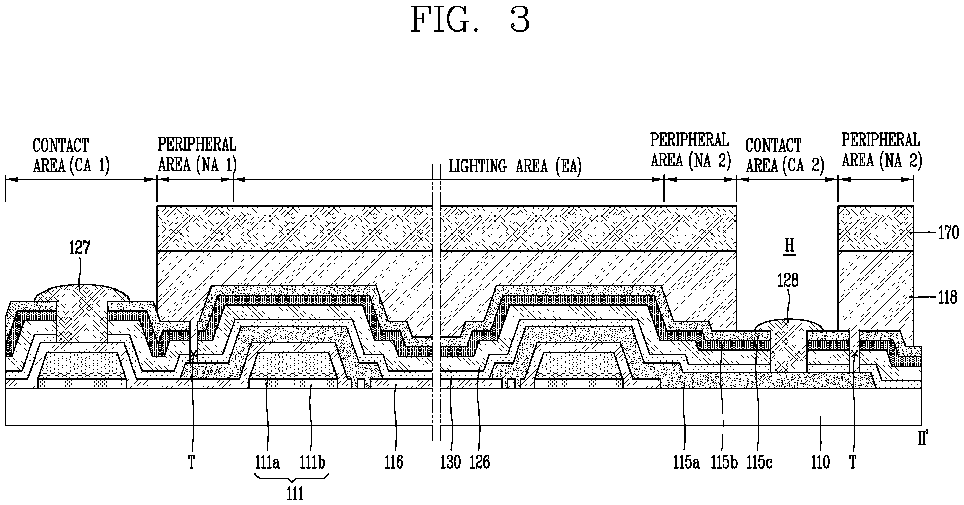

FIG. 3 is a schematic cross-sectional view of the lighting apparatus using an organic light-emitting diode according to an exemplary aspect of the present disclosure, taken along line II-II' of FIG. 2.

The present disclosure provides a lighting apparatus using an organic light-emitting diode made of organic material, rather than a lighting apparatus using an inorganic light-emitting diode made of inorganic material.

An OLED made of organic emissive material has relatively good green and red emission efficiency compared to an inorganic light-emitting diode. Another advantage of the OLED is that it offers an improved color rendering index because of its relatively broad red, green, and blue emission peak widths compared to the inorganic light-emitting diode, thereby generating light more close to sunlight.

In the description below, the lighting apparatus of the disclosure is described as a lighting apparatus that flexibly bends, but the present disclosure may be applicable not only to a bendable lighting apparatus, but also to general lighting apparatuses that are not bendable.

Referring to FIGs. 1 to 3, a lighting apparatus 100 using an organic light-emitting diode according to an exemplary aspect of the present disclosure may include an organic light-emitting diode part 101 where surface emission occurs, and a sealing part 102 that seals the organic light-emitting diode part 101.

In this case, an external light extraction layer 145 for increasing haze may be added to the bottom of the organic light-emitting diode part 101.

The external light extraction layer 145 is made of scattering particles of TiO2, etc. dispersed in resin, and may be attached to the bottom of a substrate 110 through an adhesive layer (not shown).

The organic light-emitting diode part 101 is made up of organic light-emitting diodes placed on the substrate 110. In this case, an internal light extraction layer 140 may be added between the substrate 110 and the organic light-emitting diodes.

A planarization layer (not shown) may be added to the top of the internal light extraction layer 140.

In this case, the substrate 110 may be divided into a lighting area EA that actually emits light and sends it out, and peripheral areas NA1 and NA2 around the lighting area EA.

The substrate 110 may additionally include contact areas CA1 and CA2 that are electrically connected externally via contact electrodes 127 and 128 and apply signals to the lighting area EA.

The contact areas CA1 and CA2 may be electrically connected externally via the contact electrodes 127 and 128 as they are not covered by a metal film 170 used as a sealing means.

The first contact area CA1 may be located outside the first peripheral area NA1, and the second contact area CA2 may be located within the second peripheral area NA2 and exposed externally via an open hole H. Accordingly, the metal film 170 may be attached to the entire surface of the lighting area EA and peripheral areas NA1 and NA2 of the substrate 110, except the open hole H.

An organic light-emitting diode is formed by a first electrode 116 and a second electrode 126 positioned on the substrate 110 and an organic emissive layer 130 situated between the first and second electrodes 116 and 126. In the lighting apparatus 100 of such a structure, when a signal is applied to the first electrode 116 and second electrode 126 of the organic light-emitting diode, the organic emissive layer 130 produces and emits light over the entire lighting area EA.

The organic emissive layer 130 may be made up of light-emitting layers that produce white light. For example, the organic emissive layer 130 may be made up of blue, red, and green emitting layers or may be made up of a blue emitting layer and a yellow-green emitting layer stacked in tandem. However, the organic emissive layer 130 of this disclosure is not limited to the above-described structure, but various structures may be applied to it.

The organic emissive layer 130 of this disclosure may further include an electron injection layer and a hole injection layer that respectively inject electrons and holes into the emitting layers, an electron transport layer and a hole transport layer that respectively transport the injected electrons and holes to the emitting layers, and a charge generating layer that generates electric charges such as electrons and holes.

A trench T exposing a first passivation layer 115a may be formed by removing a portion of the organic emissive layer 130, second electrode 126, and second and third passivation layers 115b and 115c from the peripheral areas NA1 and NA2 of the substrate 110. The trench T surrounds the lighting area EA and functions to prevent moisture from penetrating the organic emissive layer 130 in the lighting area EA. Generally, polymers used as organic emissive materials, when combined with moisture, degrade quickly in their light-emitting characteristics, and the luminous efficiency of the organic emissive layer 130 therefore decreases. Especially when the organic emissive layer 130 in the lighting apparatus 100 is partially exposed to the outside, moisture spreads into the lighting apparatus 100 along the organic emissive layer 130, thereby lowering the luminous efficiency of the lighting apparatus 100. To overcome this, in the present disclosure, the trench T is formed all around the outer perimeter of the lighting area EA, so as to prevent moisture from penetrating the organic emissive layer 130 in the lighting area EA of the lighting apparatus 100 from which light is actually produced and emitted.

Referring to FIG. 2, the trench T of this disclosure may be formed in the shape of an overall rectangular frame, recessed between the lighting area EA and the second contact area CA2, but the present disclosure is not limited to this shape.

The trench T may separate the organic emissive layer 130 along the outer perimeter of the lighting area EA, thereby preventing moisture from spreading into the lighting area EA along the organic emissive layer 130. In particular, the trench T of this disclosure may simplify the process by laser ablation without using any photolithography process.

In this case, the first electrode 116 is positioned on the substrate 110 made of transparent material. The substrate 110, although may be made of a hard material such as glass, may be made of a flexible material such as plastic to make the lighting apparatus 100 bendable. Moreover, the present disclosure allows for a roll-to-roll processing by using a flexible plastic material as the substrate 110, thus facilitating a fabrication process of the lighting apparatus 100.

The first electrode 116 is formed in the lighting area EA, first peripheral area NA1, and first contact area CA1, and may be made of a transparent conductive material with a high work function. For example, in the present disclosure, the first electrode 116 may be made of a conductive material of tin oxide, such as ITO (indium tin oxide) or a conductive material of zinc oxide, such as IZO (indium zinc oxide), or may also be made of a transparent conductive polymer.

An auxiliary electrode 111 may be placed in the lighting area EA and first contact area CA1 of the substrate 110 and electrically connected to the first electrode 116. The first electrode 116 has the advantage of being made of transparent conductive material and transmitting emitted light therethrough, but also has the disadvantage that it has very high electrical resistance compared to opaque metals. Accordingly, in the fabrication of a large-area lighting apparatus 100, an electrical current applied to a wide lighting area may not be uniformly distributed due to the high resistance of the transparent conductive material, and this non-uniform current distribution makes it impossible for the large-area lighting apparatus 100 to emit light with uniform brightness.

The auxiliary electrode 111 is positioned across the entire lighting area EA, in the shape of a matrix form of thin lines, a mesh, a hexagon, an octagon, or a circle so that an electric current is evenly applied to the first electrode 116 over the entire lighting area EA, thus enabling the large-area lighting apparatus 100 to emit light with uniform brightness.

Although FIG. 3 illustrates an example where the auxiliary electrode 111 is positioned below the first electrode 116, the present disclosure is not limited to this example, and the auxiliary electrode 111 may be positioned over the first electrode 116. The auxiliary electrode 111 placed in the first contact area CA1 may be used as a current transfer path to the first electrode 116, and also may function as a contact electrode that comes into contact with the outside and applies an external current to the first electrode 116.

The auxiliary electrode 111 may be made of a metal with high conductivity, such as Al, Au, Cu, Ti, W, Mo, or an alloy thereof. The auxiliary electrode 111 may have a two-layer structure of an upper auxiliary electrode 111a and a lower auxiliary electrode 111b, but the present disclosure is not limited to this structure, and the auxiliary electrode 111 may consist of a single layer.

The first passivation layer 115a may be stacked in the lighting area EA, peripheral areas NA1 and NA2, and second contact area CA2 of the substrate 110.

The first passivation layer 115a in the lighting area EA is configured to cover the auxiliary electrode 111 and the overlying first electrodel 16, but the first passivation layer 115a is not formed in the light emission area where light is actually emitted. In particular, the first passivation layer 115a in the lighting area EA reduces a difference in level (or step coverage) caused by the auxiliary electrode 111 as it surrounds the auxiliary electrode 111, which allows for stable formation of various layers that are to be formed later, without separation.

The first passivation layer 115a may be made of an inorganic material such as SiOₓ or SiNₓ. Alternatively, the first passivation layer 115a may be made of an organic material such as photoacryl or be made of a plurality of layers of inorganic and organic materials.

The lighting apparatus 100 using an organic light-emitting diode according to an exemplary aspect of the present disclosure is characterized in that the organic emissive layer 130, the second electrode 126, and the second and third passivation layers 115b and 115c are positioned on the entire surface of the substrate 110 where the first electrode 116 and the first passivation layer 115a are placed.

That is, the lighting apparatus 100 using an organic light-emitting diode according to an exemplary aspect of the present disclosure is characterized in that the organic emissive layer 130, the second electrode 126, and the second and third passivation layers 115b and 115c are deposited on the entire surface, without using an open mask, which is a separate, complicated tool, and then patterned by laser ablation, followed by encapsulation and the formation of the contact electrodes 127 and 128.

In this case, the trench T is formed by removing the organic emissive layer 130, the second electrode 126, and the second and third passivation layers 115a and 115b from the peripheral areas NA1 and NA2 of the substrate 110 by laser ablation. Hereupon, the surface of the first passivation layer 115a may be exposed via the trench T.

Moreover, a first contact hole exposing the first electrode 116 may be formed by removing the organic emissive layer 130, the second electrode 126, and the second and third passivation layers 115a and 115b from the first contact area CA1 of the substrate 110 by laser ablation. In addition, a second contact hole exposing the first passivation layer 115a may be formed by removing the organic emissive layer 130, the second electrode 126, and the second and third passivation layers 115a and 115b from the second contact area CA2 of the substrate 110 by laser ablation.

The first contact electrode 127, electrically connected to the first electrode 116, and the second contact electrode 128, electrically connected to the second electrode 126, may be formed in the first and second contact holes by an Ag printing process. In this case, the first and second contact electrodes 127 and 128 may be electrically connected externally, and they, along with the trench T, may prevent moisture penetration through the sides, as well as applying a signal to the lighting area EA.

When using an open mask as in the conventional art, different open masks should be used on the organic emissive layer 130, second electrode 126, and the second and third passivation layers 115b and 115c, respectively. This requires elaborate manufacturing of masks and tools. Moreover, in a roll-to-roll processing, continuous feeding should be done on the roll-to-sheet in one-pass rather than in individual sheets. Thus, complicated line equipment is required, and it is difficult to achieve precision.

Accordingly, the present disclosure, without using open masks, may reduce costs and simplify the processes and equipment, making them adaptable to a variety of models without additional cost. Moreover, OLEDs may be patterned using simple equipment, without using an open mask and other tools, which is useful for roll-to-roll manufacturing.

That is, the present disclosure allows for micro pattern forming, without using complicated masks and tools, in roll-to-roll processing as well as in glass processing. Conventionally, open masks of different shapes have been manufactured and used for different types of products. On the other hand, when a laser is used, all that has to be done is to change design information and enter it in the equipment, without any alteration of open masks. This allows for easy adaptation to various types of products.

As described above, the organic emissive layer 130 is a white organic emissive layer, and may be made up of blue, red, and green emitting layers or be made up of a blue emitting layer and a yellow-green emitting layer stacked in tandem. Moreover, the organic emissive layer 130 may include an electron injection layer and a hole injection layer that respectively inject electrons and holes into the emitting layers, an electron transport layer and a hole transport layer that respectively transport the injected electrons and holes to the emitting layers, and a charge generating layer that generates electric charges such as electrons and holes.

The second electrode 126 may be made of metal, such as Al, Mo, Cu, and Ag, or an alloy such as MoTi.

The first electrode 116, the organic emissive layer 130, and the second electrode 126 in the lighting area EA constitute an organic light-emitting diode. The first electrode 116 is the anode of the organic light-emitting diode, and the second electrode 126 is the cathode. When an electric current is applied to the first electrode 116 and the second electrode 126, electrons are injected into the organic emissive layer 130 from the second electrode 126, and holes are injected into the organic emissive layer 130 from the first electrode 116. Thereafter, an exciton is created in the organic emissive layer 130, and the decay of the exciton results in generating light that is equivalent to the difference in energy between the lowest unoccupied molecular orbital and highest occupied molecular orbital (HOMO and LUMO) of the emissive layer, causing the light to radiate downward (towards the substrate 110 in the figure).

Since the first passivation layer 115a is positioned over the auxiliary electrode 111 in the lighting area EA, the organic emissive layer 130 above the auxiliary electrode 111 does not come into direct contact with the first electrode 116 and therefore the organic light-emitting diode is not present on the auxiliary electrode 111. That is, the organic light-emitting diode in the lighting area EA is formed only in the light-emission area within the auxiliary electrode 111 that has the shape of a matrix, for example.

As the above-described trench T is formed in the peripheral areas NA1 and NA2 of the substrate 110, the organic emissive layer 130 in the lighting area EA and the organic emissive layer 130 in the peripheral areas NA1 and NA2 may be separated from each other. In the present disclosure, since the organic emissive layer 130 in the lighting area EA and the organic emissive layer 130 in the peripheral areas NA1 and NA2 are separated by the trench T, moisture penetrating the outer region of the organic emissive layer 130 may be prevented from spreading along the organic emissive layer 130 into the lighting area EA from which light is actually emitted. Moreover, in the present disclosure, the organic emissive layer 130 becomes separated by laser ablation without addition of any open mask or photolithography process, thereby avoiding an additional fabrication process and the resulting increase in cost.

Likewise, the second electrode 126 in the lighting area EA and the second electrode 126 in the peripheral areas NA1 and NA2 are separated from each other because the second electrode 126 is positioned over the organic emissive layer 130 in the lighting area EA and peripheral areas NA1 and NA2,

The second passivation layer 115b and the third passivation layer 115c may be formed on the entire surface of the substrate 110 where the second electrode 126 is formed.

The second passivation layer 115b may be made of an organic material such as photoacryl. The third passivation layer 115c may be made of an inorganic material such as SiOx and SiNₓ, but the present disclosure is not limited to them.

A given sealant may be placed over the third passivation layer 115c. Such a sealant may be an epoxy compound, an acrylate compound, or an acrylic compound.

As described above, a first contact hole and a second contact hole respectively exposing the first electrode 116 and the first passivation layer 115a are formed by removing the organic emissive layer 130, second electrode 126, and second and third passivation layers 115a and 115b from the first and second contact areas CA1 and CA2 of the substrate 110, and the first contact electrode 127 and the second contact electrode 128 may be formed in the first contact hole and the second contact hole, respectively. In this case, the first contact electrode 127 and the second contact electrode 128 are electrically connected to an external power source to apply an electrical current to the first electrode 116 and the second electrode 126, respectively. The first contact electrode 127 and the second contact electrode 128 may be made using Ag.

An adhesive 118 such as PSA (pressure sensitive adhesive) is applied over the third passivation layer 115c, and the metal film 170 is positioned over the adhesive 118 so that the metal film 170 is attached to the third passivation layer 115c to seal the lighting apparatus 100.

The adhesive 118 may be a light curing adhesive or a heat curing adhesive.

As described above, in the present disclosure, the organic emissive layer 130 is stacked on the entire surface of the substrate 110, and the trench T is formed by laser ablation to separate the organic emissive layer 130, thereby preventing moisture from penetrating and spreading into the organic emissive layer 130 in the lighting area EA.

Moreover, the present disclosure allows for roll-to-roll manufacturing since the substrate 110 is made of a flexible plastic film and the organic emissive layer 130, second electrode 126, and second and third passivation layers 155b and 115c are deposited on the entire surface. This enables rapid fabrication of the lighting apparatus 100 and reduction of manufacturing costs.

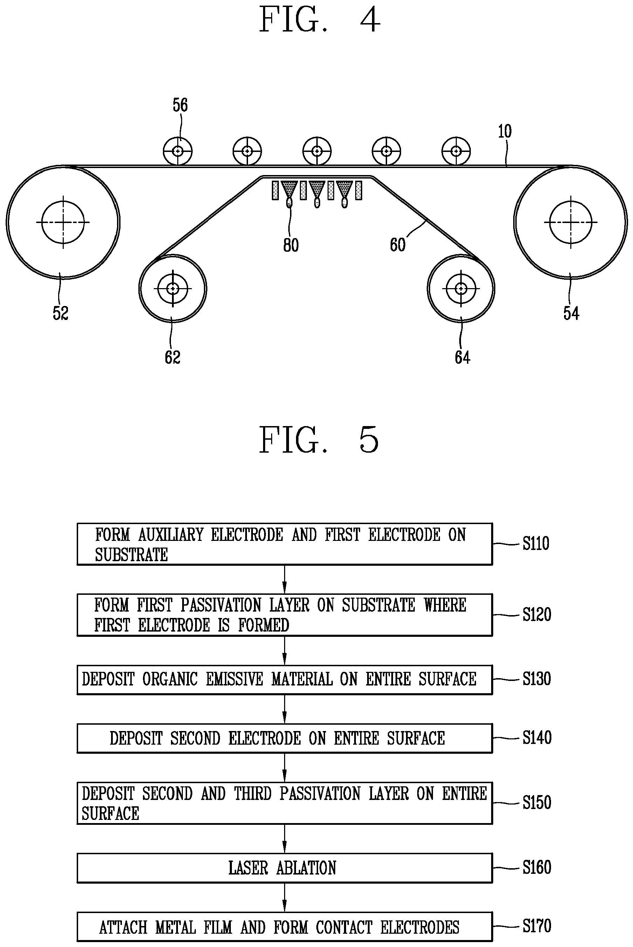

FIG. 4 is a cross-sectional view exemplifying the concept of roll-to-roll equipment for manufacturing a flexible lighting apparatus that can bend.

Referring to FIG. 4, the roll-to-roll equipment for manufacturing a flexible lighting apparatus includes a film feed roller 52 feeding a plastic film 10, a film recovery roller 54 recovering the plastic film 10, and a guide roller 56 guiding the plastic film 10.

Moreover, the roll-to-roll equipment includes a mask feed roller 62 feeding an open mask 60 (or metal mask), a mask recovery roller 64 recovering the open mask 60, and an evaporator 80 depositing an organic material or metal.

In the roll-to-roll equipment thus constructed, the plastic film 10 used as a substrate for the lighting apparatus is fed from the film feed roller 62 to the evaporator 80, and at the same time, the open mask 60 is fed from the mask feed roller 62 to the evaporator 80. With the open mask 60 positioned on the entire surface of the plastic film 10, the evaporator 80 deposits an organic material or metal in some part of the plastic film 10.

After the deposition, the open mask 60 is separated from the plastic film 10, and the plastic film 10 is recovered by the film recovery roller 64 and the open mask 60 is recovered by the mask recovery roller 64.

Using the roll-to-roll equipment with this structure, the plastic film 10 is continuously fed by the film feed roller 62, thereby facilitating a fabrication process of the lighting apparatus in a continuous process. However, this roll-to-roll equipment has the following problems.

The roll-to-roll equipment may be used in forming a variety of metal patterns - especially useful when forming an organic emissive layer, second electrode, etc. This is achieved easily by roll-to-roll manufacturing because the organic emissive layer or the second electrode is deposited across the entire area of the substrate, rather than being patterned by a photolithography process in a certain part of the substrate.

However, when an organic emissive layer is formed by depositing an organic emissive material on the entire surface of the substrate by the roll-to-roll equipment, the side of the organic emissive layer deposited over the entire surface is formed at the same level as the side of the substrate, thus causing the organic emissive layer to be exposed to the outside through the side of the lighting apparatus. The organic emissive material is susceptible to moisture and, when combined with moisture, degrades quickly, causing the moisture to spread easily. Accordingly, the organic emissive layer should be kept from being exposed to external atmosphere in the fabrication of the lighting apparatus, in order to prevent the lighting apparatus from becoming defective due to the spread of moisture through the externally exposed organic emissive layer.

Hence, as the open mask blocks the perimeter area of the substrate, the organic emissive layer is not deposited in the perimeter area of the substrate when depositing the organic emissive material. Moreover, by sealing the perimeter area with a sealant or adhesive, the side of the organic emissive layer is sealed, and this prevents the organic emissive layer from being exposed to the external atmosphere.

However, when forming an organic emissive layer using the open mask 60, as shown in FIG. 4, a system (a feed roll, guide roll, recovery roll, etc.) that feeds the plastic film 10 and a system that feeds the open mask 60 should be integrated inline. This increases not only the length of the process line but also the length of the open mask 60. Moreover, the plastic film 10 and the open mask 60 should be fed in sync, and also need to be aligned in a continuous process. In addition, the open mask 60 should be cleaned after use, which is difficult due to the long length of the open mask 60.

In other words, although a roll-to-roll manufacturing process requires the use of an open mask to enable rapid fabrication of a lighting apparatus, the open mask makes it practically difficult to fabricate the lighting apparatus by using the roll-to-roll equipment.

On the other hand, in the present disclosure, a trench is formed by removing the organic emissive layer from the peripheral areas of the substrate by laser ablation. As such, the organic emissive layer becomes separated by the trench, even when an organic emissive layer is deposited across the entire area of the substrate and the side of the organic emissive layer is therefore exposed to the external atmosphere, thereby preventing moisture from penetrating into the lighting area through the exposed organic emissive layer. Accordingly, a lighting apparatus according to the present disclosure is fabricated without using an open mask, and this simplifies the fabrication process of the lighting apparatus, making it useful especially in roll-to-roll manufacturing.

In what follows, a lighting apparatus according to an exemplary aspect of the present disclosure and a method of fabricating a lighting apparatus with a typical structure by roll-to-roll processing will be described to explain the benefits of the fabrication process of a lighting apparatus according to an exemplary aspect of the present disclosure.

FIG. 5 is a flowchart sequentially showing a method of fabricating a lighting apparatus using an organic light-emitting diode according to an exemplary aspect of the present disclosure.

Referring to FIG. 5, firstly, an auxiliary electrode and a first electrode are formed on a substrate made of a flexible, transparent plastic film (S110), and then a first passivation layer is formed by stacking and etching an inorganic material (S120). The auxiliary electrode, first electrode, and first passivation layer may be formed inside roll-to-roll equipment by a photolithographic process using a photoresist and a photomask.

Subsequently, an organic emissive layer is formed by depositing an organic emissive material on the entire surface of the substrate by using the roll-to-roll equipment shown in FIG. 4 (S130). Since, in the present disclosure, an organic emissive material is deposited without using an open mask, the roll-to-roll equipment shown in FIG. 4 does not require the use of an open mask, mask feed roller, and mask recovery roller.

Afterwards, a second electrode is formed by depositing a metal on the entire surface of the substrate (S140), and then second and third passivation layers are deposited on the entire surface of the substrate (S150).

Subsequently, a trench is formed in peripheral areas of the substrate by removing the organic emissive layer, second electrode, and second and third passivation layers by laser ablation, and at the same time first and second contact holes are formed in contact areas (S160).

Afterwards, a metal film is attached with an adhesive, and then contact electrodes are formed in the contact areas and electrically connected to the first and second electrodes (S170).

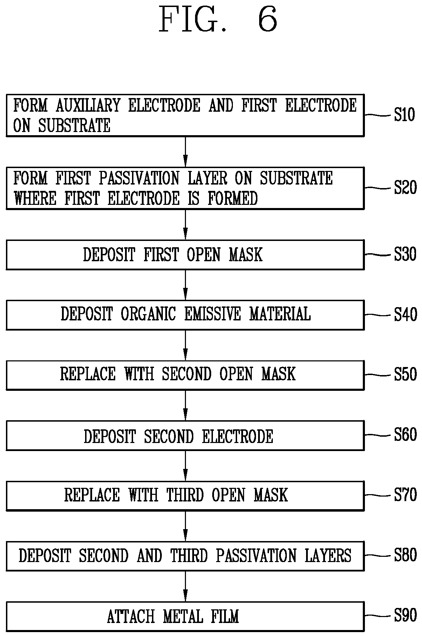

FIG. 6 is a flowchart sequentially showing a method of fabricating a lighting apparatus using an organic light-emitting diode according to a comparative example.

Referring to FIG. 6, firstly, an auxiliary electrode and a first electrode are formed on a substrate made of a flexible, transparent plastic film (S10), and then a first passivation layer is formed by stacking and etching an inorganic material (S20).

Subsequently, a first open mask (metal mask) is placed on the entire surface of the substrate, and then an organic emissive layer is formed by depositing an organic emissive material (S30 and S40).

Afterwards, the first open mask placed on the entire surface of the substrate is replaced with a new, second open mask, and then a metal is deposited to form a second electrode (S50 and S60).

Subsequently, the second open mask placed on the entire surface of the substrate is replaced with a new, third open mask, and then second and third passivation layers are formed (S70 and S80).

Afterwards, a metal film is attached with an adhesive, thereby completing a lighting apparatus (S90).

As described above, the present disclosure requires no open mask when fabricating a lighting apparatus by using roll-to-roll equipment. Thus, the step of placing an open mask and the step of replacing the open mask are not needed, unlike with the lighting apparatus according to the comparative example. Therefore, the lighting apparatus according to an exemplary aspect of the present disclosure allows for rapid fabrication.

Moreover, in the case of the lighting apparatus according to the comparative example, the open masks used in the previous process should be cleaned after completion of the process on the plastic film on the feed roller, before a plastic film is fed to the feed roller to resume the process. By contrast, the fabrication of a lighting apparatus according to an exemplary aspect of the present disclosure does not require cleaning of open masks. Accordingly, no cleaning equipment is required when fabricating a lighting apparatus according to an exemplary aspect of the present disclosure. This may reduce costs and prevent environmental contamination caused by cleaning. Moreover, no cleaning process is required between two consecutive deposition processes, thereby making the fabrication even more rapid.

Additionally, the lighting apparatus according to the comparative example requires equipment for positioning an open mask in front of the substrate, whereas the exemplary aspect of the present disclosure does not require such equipment, thereby simplifying the manufacturing equipment and reducing costs.

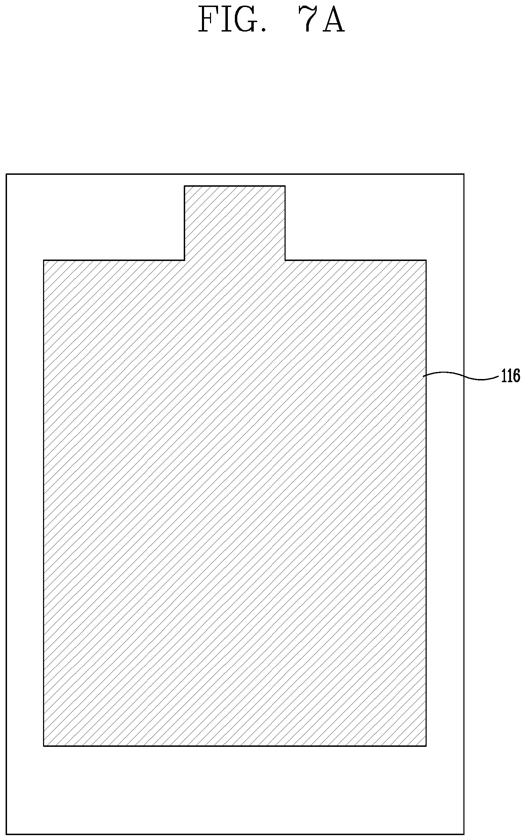

FIGs. 7A to 7E are plan views sequentially showing a method of fabricating the lighting apparatus using an organic light-emitting diode, shown in FIG. 2, according to an exemplary aspect of the present disclosure.

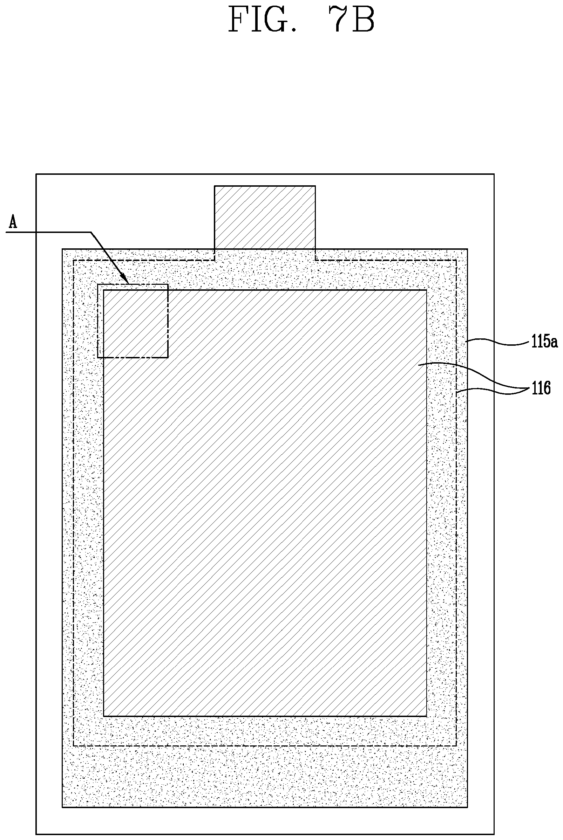

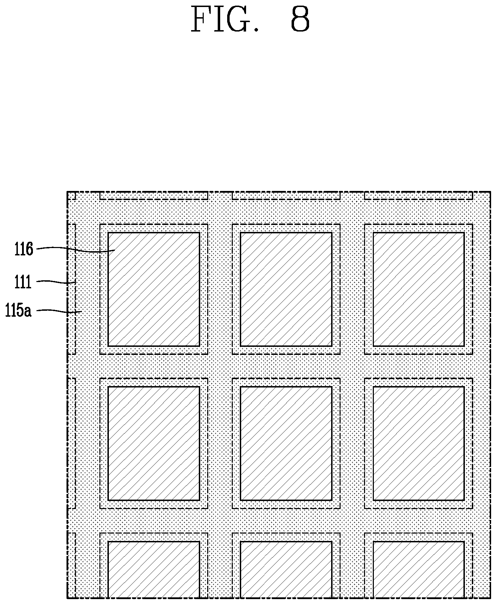

FIG. 8 is an enlarged view of the portion A of FIG. 7B.

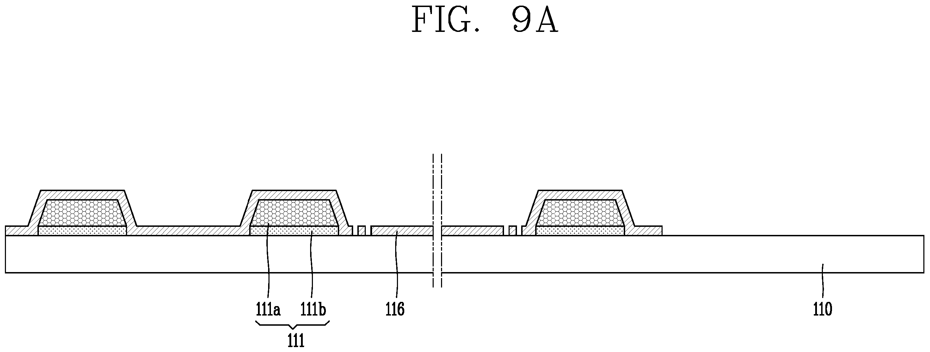

FIGs. 9A to 9E are cross-sectional views sequentially showing a method of fabricating the lighting apparatus using an organic light-emitting diode, shown in FIG. 3, according to an exemplary aspect of the present disclosure.

While the fabrication method here is illustrated with reference to a process carried out on roll-to-roll equipment, the present disclosure is not limited to the roll-to-roll equipment but may be applicable equally to general manufacturing equipment using a glass substrate.

First of all, referring to FIGs. 7A and 9A, a metal such as Al, Au, Cu, Ti, W, Mo, or an alloy thereof is deposited on a substrate 110 which is divided into a lighting area, peripheral areas, and contact areas, and then etched to form an auxiliary electrode 111 consisting of a single layer or a plurality of layers in the lighting area and the first contact area.

Although FIGs. 7A and 9A illustrate an example where the auxiliary electrode 111 is formed of a two-layer structure of an upper auxiliary electrode 111a and a lower auxiliary electrode 111b, the present disclosure is not limited to this example, as stated above.

The auxiliary electrode 111 may be positioned across the entire lighting area EA, in the shape of a matrix of thin lines (see FIG. 8), a mesh, a hexagon, an octagon, or a circle.

Afterwards, a transparent conductive material such as ITO or IZO is stacked on the entire substrate 110 and etched to form a first electrode 116 in the first peripheral area and the first contact area.

While FIGs. 7A and 9A illustrate an example where the auxiliary electrode 111 is formed below the first electrode 116, the present disclosure is not limited to this example, and the auxiliary electrode 111 may be formed over the first electrode 116. The auxiliary electrode 111 placed in the first contact area may be used as a current transfer path to the first electrode 116, and also may function as a contact electrode that comes into contact with the outside and applies an external current to the first electrode 116.

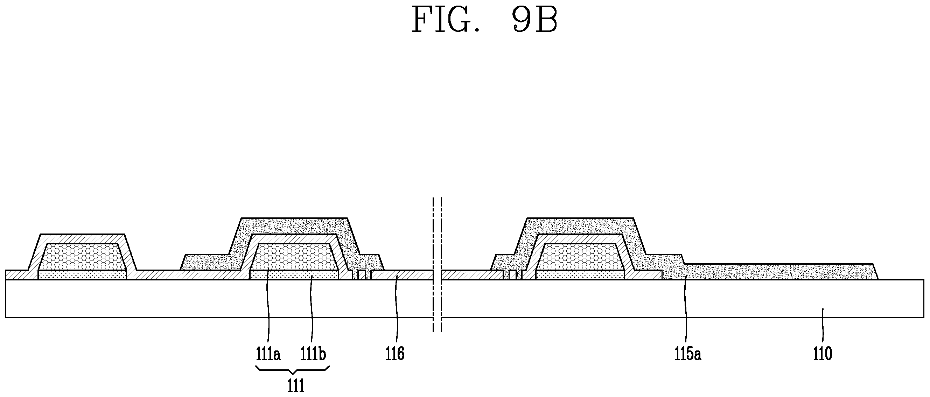

Subsequently, referring to FIGs. 7B and 9B, an inorganic material such as SiNx or SiOₓ or an organic material such as photoacryl is stacked in the lighting area, peripheral areas, and second contact area of the substrate 110. Afterwards, the inorganic material or organic material is etched to form a first passivation layer 115a on the top and side of the auxiliary electrode 111 in the lighting area and in a certain part of the peripheral areas.

The first passivation layer 115a in the lighting area is configured to cover the auxiliary electrode 111 and the overlying first electrode 116, but the first passivation layer 115a is not formed in the light emission area where light is actually emitted (although in practice, referring to FIG. 8, the first passivation layer 115a may be formed in a matrix shape in the light-emission area). In particular, the first passivation layer 115a in the lighting area reduces the difference in level caused by the auxiliary electrode 111 as it surrounds the auxiliary electrode 111, which allows for stable formation of various layers that are to be formed later, without separation.

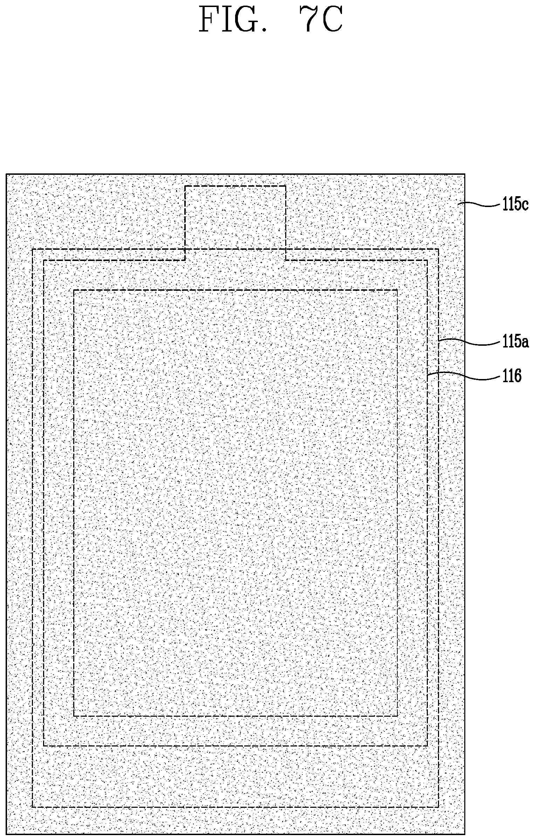

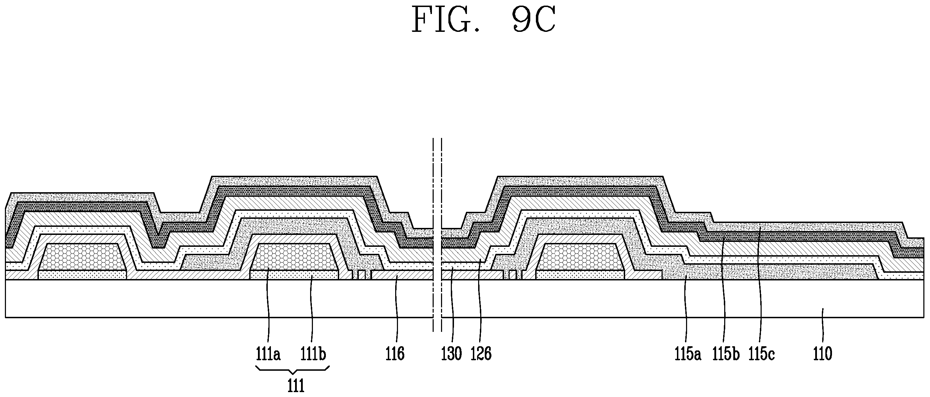

Subsequently, referring to FIGs. 7C and 9C, an organic emissive layer 130, a second electrode 126, a second passivation layer 115b, and a third passivation layer 115c are formed by sequentially depositing an organic emissive material, a metal, an organic insulating material, and an inorganic insulating material across the entire surface of the substrate 110.

In this case, the organic emissive layer 130 is a white organic emissive layer, and may be made up of blue, red, and green emitting layers or be made up of a blue emitting layer and a yellow-green emitting layer stacked in tandem. Moreover, the organic emissive layer 130 may include an electron injection layer and a hole injection layer that respectively inject electrons and holes into the emitting layers, an electron transport layer and a hole transport layer that respectively transport the injected electrons and holes to the emitting layers, and a charge generating layer that generates electric charges such as electrons and holes.

The second electrode 126 may be made of metal, such as Al, Mo, Cu, and Ag, or an alloy such as MoTi.

The first electrode 116, organic emissive layer 130, and second electrode 126 in the lighting area constitute an organic light-emitting diode.

Since the first passivation layer 115a is positioned over the auxiliary electrode 111 in the lighting area, the organic emissive layer 130 above the auxiliary electrode 111 does not come into direct contact with the first electrode 116 and therefore the organic light-emitting diode is not present on the auxiliary electrode 111. That is, the organic light-emitting diode in the lighting area is formed only in the light-emission area within the auxiliary electrode 111 that has the shape of a matrix, for example (see FIG. 8).

As such, in the lighting apparatus using an organic light-emitting diode according to the exemplary aspect of the present disclosure, the organic emissive layer 130, second electrode 126, and second and third passivation layers 115b and 115c are deposited on the entire surface, without using an open mask, which is a separate, complicated tool, and this may reduce costs and simplify the processes and equipment, making them adaptable to a variety of models without additional cost. Moreover, OLEDs may be patterned using simple equipment, without using an open mask and other tools, which is useful for roll-to-roll manufacturing.

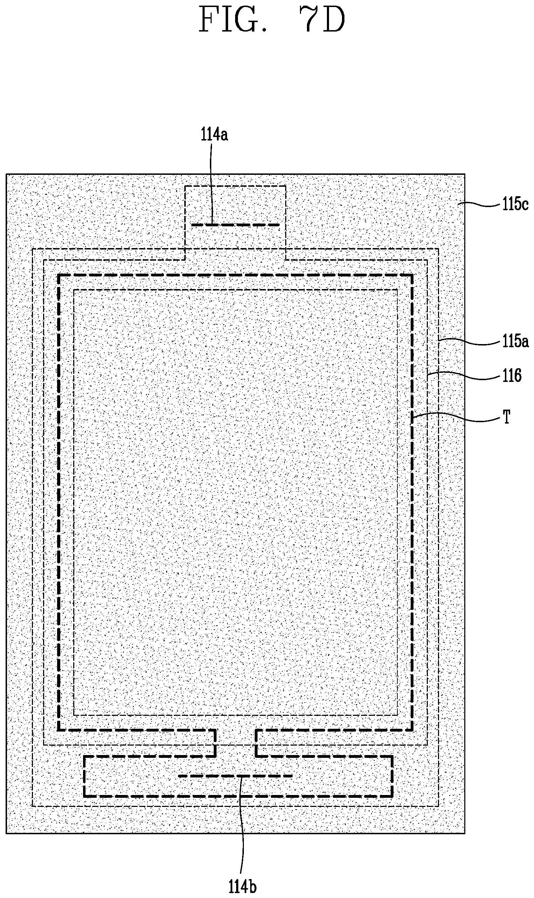

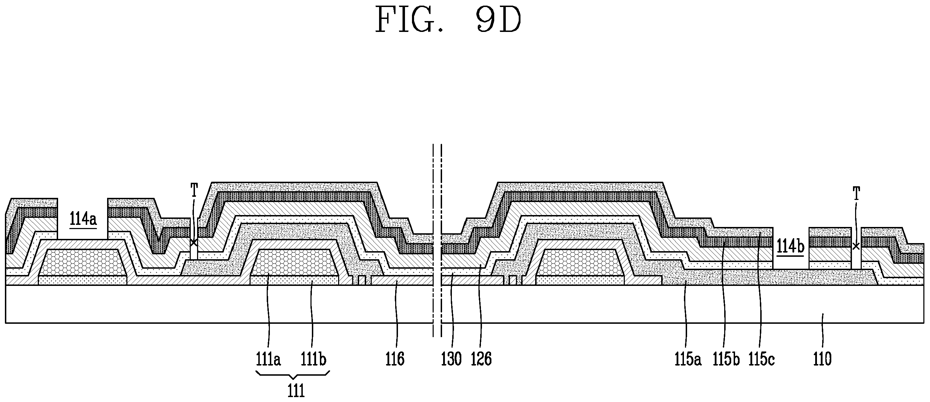

Subsequently, referring to FIGs. 7D and 9D, a trench T exposing the surface of the first passivation layer 115a is formed in the peripheral areas of the substrate 110 by partially removing the organic emissive layer 130, second electrode 126, and second and third passivation layers 115a and 115b which are deposited over the entire surface.

Additionally, using laser ablation, a first contact hole 114a exposing the first electrode 116 may be formed by removing the organic emissive layer 130, second electrode 126, and second and third passivation layers 115a and 115b from the first contact area of the substrate 110, and at the same time, a second contact hole 114b exposing the first passivation layer 115a may be formed by removing the organic emissive layer 130, second electrode 126, and second and third passivation layers 115a and 115b from the second contact area of the substrate 110.

As the above-described trench T is formed in the peripheral areas of the substrate 110, the organic emissive layer 130 in the lighting area and the organic emissive layer 130 in the peripheral areas may be separated from each other. In the present disclosure, since the organic emissive layer 130 in the lighting area and the organic emissive layer 130 in the peripheral areas are separated by the trench T, moisture penetrating the outer region of the organic emissive layer 130 may be prevented from spreading along the organic emissive layer 130 into the lighting area from which light is actually emitted. Moreover, in the present disclosure, the organic emissive layer 130 becomes separated by laser ablation without addition of any open mask or photolithography process, thereby avoiding an additional fabrication process and the resulting increase in cost.

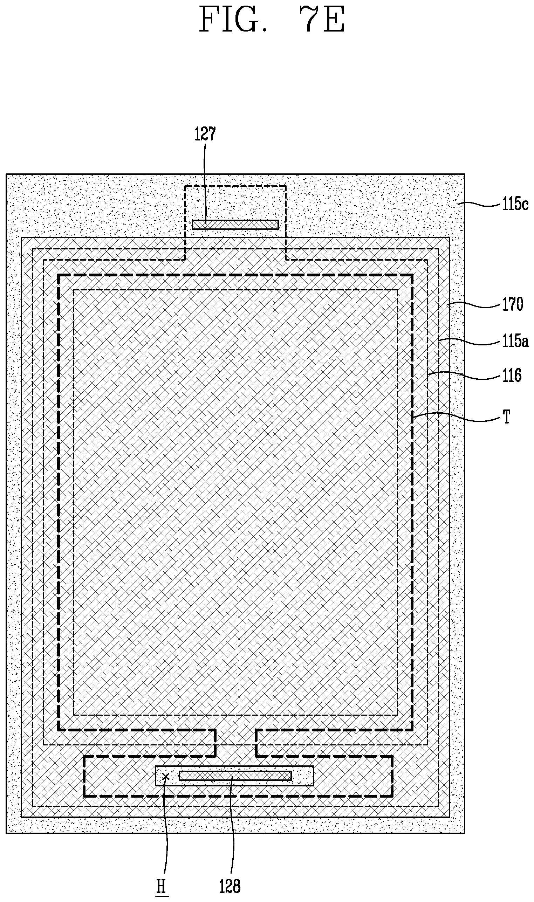

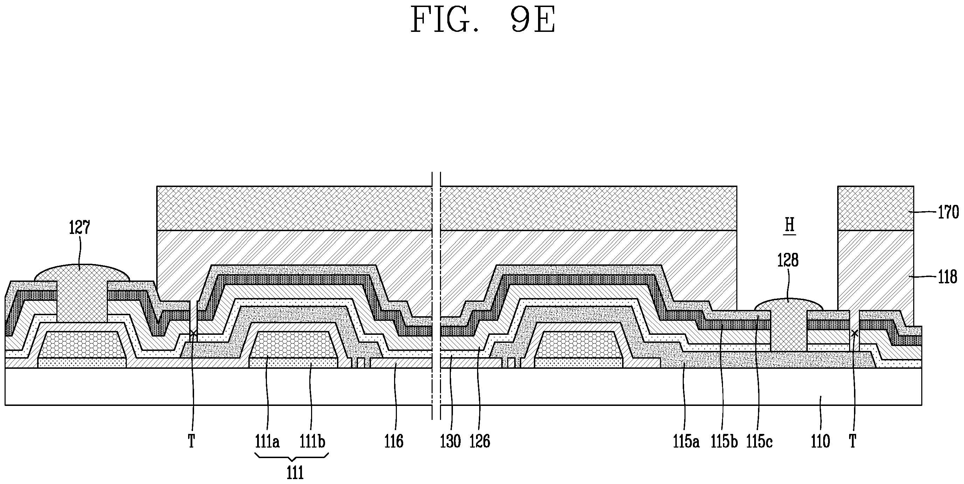

Subsequently, referring to FIGs. 7E and 9E, a first contact electrode 127, electrically connected to the first electrode 116 via the first contact hole 114a, and a second contact electrode 128, electrically connected to the second electrode 126 via the second contact hole 114b, are formed by Ag printing.

In this case, the first and second contact electrodes 127 and 128 may be electrically connected externally, and they, along with the trench T, may prevent moisture penetration through the sides, as well as applying a signal to the lighting area.

Afterwards, an adhesive 118 made of a light curing adhesive material or a heat curing adhesive material is applied over the substrate 110. Further, a metal film 170 is positioned over the adhesive 118, and then the adhesive 118 is cured to attach the metal film 117, thereby completing the lighting apparatus.

## Claims

1. A lighting apparatus (100) using an organic light-emitting diode, comprising:
a substrate (110) having a lighting area (EA), first and second peripheral areas (NA1, NA2), and first and second contact areas (CA1, CA2);
a first electrode (116) on the substrate (110);
a first passivation layer (115a) on the first electrode (116) ;
a trench (T) in the peripheral areas (NA1, NA2);
an organic emissive layer (130), a second electrode (126), and a second passivation layer (115b) on the entire surface of the substrate (110) including the first passivation layer (115a), except for an area of the trench (T), at least a portion of the first contact area (C1) and at least a portion of the second contact area (C2);
the trench (T) being all around the outer perimeter of the lighting area (EA) and separating the organic emissive layer (130) in the lighting area (EA) from the organic emissive layer (130) outside the lighting area (EA) ;
an adhesive (118) on the second passivation layer (115b) including an inside of the trench (T); and
a metal film (170) on the adhesive (118) in the lighting area (EA) and the first and second peripheral areas (NA1, NA2) .

2. The lighting apparatus (100) of claim 1, wherein the first electrode (116) is disposed at the lighting area (EA), first and second peripheral areas (NA1, NA2), and the first contact area (CA1).

3. The lighting apparatus (100) of claim 1 or 2, wherein the first passivation layer (115a) is disposed at the lighting area (EA) and the first and second peripheral areas (NA1, NA2) where the first electrode (116) and the second contact area (CA2) are formed.

4. The lighting apparatus (100) of any one of claims 1 to 3, wherein a portion of the first passivation layer (115a) is exposed by the trench (T), wherein, preferably, the adhesive layer (118) is disposed in the trench (T).

5. The lighting apparatus (100) of claim 4, wherein the trench (T) has a rectangular shape along an outer perimeter of the lighting area (EA), in the peripheral areas (NA1, NA2) of the substrate (110).

6. The lighting apparatus (100) of any one of claims 1 to 5, further comprising first and second contact electrodes (127, 128) placed at the first and second contact areas (CA1, CA2) of the substrate (110) and electrically connected to the first and second electrodes (116, 126), respectively.

7. The lighting apparatus (100) of any one of claims 1 to 6, wherein the second contact area (CA2) of the substrate (110) is positioned at the second peripheral area (NA2) of the substrate (110), and exposes the second contact electrode (128) to an outside of the apparatus (100).

8. The lighting apparatus (100) of any one of claims 1 to 7, wherein the organic emissive layer (130), the second electrode (126), and the second passivation layer (115b) are exposed at an outermost side area of the substrate (110) .

9. A method of fabricating a lighting apparatus (100) using an organic light-emitting diode, the method comprising:
forming a first electrode (116) on a substrate (110) having a lighting area (EA), first and second peripheral areas (NA1, NA2), and first and second contact areas (CA1, CA2); forming a first passivation layer (115a) on the substrate (110) where the first electrode (116) is formed;
forming an organic emissive layer (130), a second electrode (126), and a second passivation layer (115b) on the entire surface of the substrate (110) including the first passivation layer (115a);
forming a trench (T) in the peripheral areas (NA1, NA2) all around the outer perimeter of the lighting area (EA) by removing the organic emissive layer (130), the second electrode (126), and the second passivation layer (115b) from the outer perimeter of the lighting area (EA), the trench (T) separating the organic emissive layer (130) in the lighting area (EA) from the organic emissive layer (130) outside the lighting area (EA); and
attaching a metal film (170) on the second passivation layer (115b) in the lighting area (EA) and the first and second peripheral areas (NA1, NA2), with an adhesive (118) in between.

10. The method of claim 9, wherein the first electrode (116) is formed in the lighting area (EA), the first and second peripheral areas (NA1, NA2), and the first contact area (CA1) of the substrate (110).

11. The method of claim 9 or 10, wherein the first passivation layer (115a) is formed in the lighting area (EA) and the first and the second peripheral areas (NA1, NA2) of the substrate (110) where the first electrode (116) and the second contact area of the substrate (110) are formed.

12. The method of any one of claims 9 to 11, wherein the trench (T) exposes a portion of the first passivation layer (115a) by removing portions of the organic emissive layer (130), the second electrode (126), and the second passivation layer (115b) from the first and second peripheral areas (NA1, NA2) of the substrate (110) through laser ablation.

13. The method of claim 12, wherein the adhesive layer (117) is disposed in the trench (T) that is formed by removing the portions of the organic emissive layer (130), the second electrode (126), and the second passivation layer (115b).

14. The method of any one of claims 9 to 13, further comprising, when forming the trench (T), simultaneously forming first and second contact holes (114a, 114b) exposing the first electrode (116) and the first passivation layer (115a) by removing the organic emissive layer (130), the second electrode (126), and the second passivation layer (115b) from the first and second contact areas (CA1, CA2) of the substrate (110).

15. The method of claim 14, further comprising forming first and second contact electrodes (127, 128) in the first and second contact areas (CA1, CA2) of the substrate (110), the first and second contact electrodes (127, 128) being electrically connected to the first and second electrodes (116, 126) via the first and second contact holes (114a, 114b) after the forming first and second contact holes (114a, 114b).

## Patentansprüche

1. Beleuchtungsvorrichtung (100), die eine organische lichtemittierende Diode verwendet, aufweisend:
ein Substrat (110), das einen Beleuchtungsbereich (EA), einen ersten und einen zweiten Randbereich (NA1, NA2) und einen ersten und einen zweiten Kontaktbereich (CA1, CA2) aufweist;
eine erste Elektrode (116) auf dem Substrat (110);
eine erste Passivierungsschicht (115a) auf der ersten Elektrode (116);
einen Graben (T) in den Randbereichen (NA1, NA2);
eine organische Emissionsschicht (130), eine zweite Elektrode (126) und eine zweite Passivierungsschicht (115b) auf der gesamten Fläche des Substrats (110) einschließlich der ersten Passivierungsschicht (115a), mit Ausnahme eines Bereichs des Grabens (T), mindestens eines Abschnitts des ersten Kontaktbereichs (C1) und mindestens eines Abschnitts des zweiten Kontaktbereichs (C2);
wobei der Graben (T) um den gesamten äußeren Umfang des Beleuchtungsbereichs (EA) herum verläuft und die organische Emissionsschicht (130) im Beleuchtungsbereich (EA) von der organischen Emissionsschicht (130) außerhalb des Beleuchtungsbereichs (EA) trennt;
ein Haftmittel (118) auf der zweiten Passivierungsschicht (115b) einschließlich einer Innenseite des Grabens (T); und
einen Metallfilm (170) auf dem Haftmittel (118) im Beleuchtungsbereich (EA) und dem ersten und dem zweiten Randbereich (NA1, NA2).

2. Beleuchtungsvorrichtung (100) gemäß Anspruch 1, wobei die erste Elektrode (116) an dem Beleuchtungsbereich (EA), dem ersten und dem zweiten Randbereich (NA1, NA2) und dem ersten Kontaktbereich (CA1) angeordnet ist.

3. Beleuchtungsvorrichtung (100) gemäß Anspruch 1 oder 2, wobei die erste Passivierungsschicht (115a) an dem Beleuchtungsbereich (EA) und dem ersten und dem zweiten Randbereich (NA1, NA2) angeordnet ist, wo die erste Elektrode (116) und der zweite Kontaktbereich (CA2) ausgebildet sind.

4. Beleuchtungsvorrichtung (100) gemäß irgendeinem der Ansprüche 1 bis 3, wobei ein Abschnitt der ersten Passivierungsschicht (115a) durch den Graben (T) freigelegt ist, wobei die Haftmittelschicht (118) vorzugsweise in dem Graben (T) angeordnet ist.

5. Beleuchtungsvorrichtung (100) gemäß Anspruch 4, wobei der Graben (T) entlang eines äußeren Umfangs des Beleuchtungsbereichs (EA) in den Randbereichen (NA1, NA2) des Substrats (110) eine rechteckige Form hat.

6. Beleuchtungsvorrichtung (100) gemäß irgendeinem der Ansprüche 1 bis 5, ferner aufweisend eine erste und eine zweite Kontaktelektrode (127, 128), die an dem ersten und dem zweiten Kontaktbereich (CA1, CA2) des Substrats (110) angeordnet sind und elektrisch mit der ersten bzw. der zweiten Elektrode (116, 126) verbunden sind.

7. Beleuchtungsvorrichtung (100) gemäß irgendeinem der Ansprüche 1 bis 6, wobei der zweite Kontaktbereich (CA2) des Substrats (110) an dem zweiten Randbereich (NA2) des Substrats (110) positioniert ist und die zweite Kontaktelektrode (128) zu einer Außenseite der Vorrichtung (100) hin freilegt.

8. Beleuchtungsvorrichtung (100) gemäß irgendeinem der Ansprüche 1 bis 7, wobei die organische Emissionsschicht (130), die zweite Elektrode (126) und die zweite Passivierungsschicht (115b) an einem äußersten Seitenbereich des Substrats (110) freigelegt sind.

9. Verfahren zum Herstellen einer Beleuchtungsvorrichtung (100), die eine organische lichtemittierende Diode verwendet, wobei das Verfahren aufweist:
Ausbilden einer ersten Elektrode (116) auf einem Substrat (110), das einen Beleuchtungsbereich (EA), einen ersten und einen zweiten Randbereich (NA1, NA2) und einen ersten und einen zweiten Kontaktbereich (CA1, CA2) aufweist;
Ausbilden einer ersten Passivierungsschicht (115a) auf dem Substrat (110), wo die erste Elektrode (116) ausgebildet ist;
Ausbilden einer organischen Emissionsschicht (130), einer zweiten Elektrode (126) und einer zweiten Passivierungsschicht (115b) auf der gesamten Fläche des Substrats (110) einschließlich der ersten Passivierungsschicht (115a);
Ausbilden eines Grabens (T) in den Randbereichen (NA1, NA2) um den gesamten äußeren Umfang des Beleuchtungsbereichs (EA) herum durch Entfernen der organischen Emissionsschicht (130), der zweiten Elektrode (126) und der zweiten Passivierungsschicht (115b) vom äußeren Umfang des Beleuchtungsbereichs (EA), wobei der Graben (T) die organische Emissionsschicht (130) im Beleuchtungsbereich (EA) von der organischen Emissionsschicht (130) außerhalb des Beleuchtungsbereichs (EA) trennt; und
Anbringen eines Metallfilms (170) auf der zweiten Passivierungsschicht (115b) im Beleuchtungsbereich (EA) und dem ersten und dem zweiten Randbereich (NA1, NA2) mit einem Haftmittel (118) dazwischen.

10. Verfahren gemäß Anspruch 9, wobei die erste Elektrode (116) im Beleuchtungsbereich (EA), dem ersten und dem zweiten Randbereich (NA1, NA2) und dem ersten Kontaktbereich (CA1) des Substrats (110) ausgebildet wird.

11. Verfahren gemäß Anspruch 9 oder 10, wobei die erste Passivierungsschicht (115a) in dem Beleuchtungsbereich (EA) und dem ersten und dem zweiten Randbereich (NA1, NA2) des Substrats (110) ausgebildet wird, wo die erste Elektrode (116) und der zweite Kontaktbereich des Substrats (110) ausgebildet werden.

12. Verfahren gemäß irgendeinem der Ansprüche 9 bis 11, wobei der Graben (T) einen Abschnitt der ersten Passivierungsschicht (115a) freilegt, durch Entfernen von Abschnitten der organischen Emissionsschicht (130), der zweiten Elektrode (126) und der zweiten Passivierungsschicht (115b) von dem ersten und dem zweiten Randbereich (NA1, NA2) des Substrats (110) durch Laserablation.

13. Verfahren gemäß Anspruch 12, wobei die Haftmittelschicht (117) in dem Graben (T) angeordnet wird, der durch Entfernen der Abschnitte der organischen Emissionsschicht (130), der zweiten Elektrode (126) und der zweiten Passivierungsschicht (115b) gebildet wird.

14. Verfahren gemäß irgendeinem der Ansprüche 9 bis 13, ferner aufweisend: beim Ausbilden des Grabens (T) gleichzeitiges Ausbilden eines ersten und eines zweiten Kontaktlochs (114a, 114b), die die erste Elektrode (116) und die erste Passivierungsschicht (115a) freilegen, durch Entfernen der organischen Emissionsschicht (130), der zweiten Elektrode (126) und der zweiten Passivierungsschicht (115b) von dem ersten und dem zweiten Kontaktbereich (CA1, CA2) des Substrats (110).

15. Verfahren gemäß Anspruch 14, ferner aufweisend:
Ausbilden einer ersten und einer zweiten Kontaktelektrode (127, 128) in dem ersten und dem zweiten Kontaktbereich (CA1, CA2) des Substrats (110), wobei die erste und die zweite Kontaktelektrode (127, 128) nach dem Ausbilden des ersten und des zweiten Kontaktlochs (114a, 114b) über das erste und das zweite Kontaktloch (114a, 114b) elektrisch mit der ersten und der zweiten Elektrode (116, 126) verbunden werden.

## Revendications

1. Appareil d'éclairage (100) utilisant une diode électroluminescente organique, comprenant :
un substrat (110) ayant une zone d'éclairage (EA), des première et deuxième zones périphériques (NA1, NA2), et des première et deuxième zones de contact (CA1, CA2) ;
une première électrode (116) sur le substrat (110) ;
une première couche de passivation (115a) sur la première électrode (116) ;
une tranchée (T) dans les zones périphériques (NA1, NA2) ;
une couche organique émissive (130), une deuxième électrode (126) et une deuxième couche de passivation (115b) sur toute la surface du substrat (110), y compris la première couche de passivation (115a), à l'exception d'une zone de la tranchée (T), au moins une partie de la première zone de contact (C1) et au moins une partie de la deuxième zone de contact (C2) ;
la tranchée (T) étant située tout autour du périmètre extérieur de la zone d'éclairage (EA) et séparant la couche organique émissive (130) dans la zone d'éclairage (EA) de la couche organique émissive (130) à l'extérieur de la zone d'éclairage (EA) ;
un adhésif (118) sur la deuxième couche de passivation (115b) y compris un intérieur de la tranchée (T) ; et
un film métallique (170) sur l'adhésif (118) dans la zone d'éclairage (EA) et les première et deuxième zones périphériques (NA1, NA2).

2. Appareil d'éclairage (100) selon la revendication 1, dans lequel la première électrode (116) est disposée au niveau de la zone d'éclairage (EA), des première et deuxième zones périphériques (NA1, NA2) et de la première zone de contact (CA1).

3. Appareil d'éclairage (100) selon la revendication 1 ou 2, dans lequel la première couche de passivation (115a) est disposée au niveau de la zone d'éclairage (EA) et des première et deuxième zones périphériques (NA1, NA2), où la première électrode (116) et la deuxième zone de contact (CA2) sont formées.

4. Appareil d'éclairage (100) selon l'une quelconque des revendications 1 à 3, dans lequel une partie de la première couche de passivation (115a) est exposée par la tranchée (T), dans lequel, de préférence, la couche d'adhésif (118) est disposée dans la tranchée (T).

5. Appareil d'éclairage (100) selon la revendication 4, dans lequel la tranchée (T) a une forme rectangulaire le long d'un périmètre extérieur de la zone d'éclairage (EA), dans les zones périphériques (NA1, NA2) du substrat (110).

6. Appareil d'éclairage (100) selon l'une quelconque des revendications 1 à 5, comprenant en outre des première et deuxième électrodes de contact (127, 128) placées au niveau des première et deuxième zones de contact (CA1, CA2) du substrat (110) et connectées électriquement aux première et deuxième électrodes (116, 126), respectivement.

7. Appareil d'éclairage (100) selon l'une quelconque des revendications 1 à 6, dans lequel la deuxième zone de contact (CA2) du substrat (110) est positionnée au niveau de la deuxième zone périphérique (NA2) du substrat (110), et expose la deuxième électrode de contact (128) à un extérieur de l'appareil (100).

8. Appareil d'éclairage (100) selon l'une quelconque des revendications 1 à 7, dans lequel la couche organique émissive (130), la deuxième électrode (126) et la deuxième couche de passivation (115b) sont exposées au niveau d'une zone latérale la plus extérieure du substrat (110).

9. Procédé de fabrication d'un appareil d'éclairage (100) utilisant une diode électroluminescente organique, le procédé comprenant les étapes suivantes consistant à :
former une première électrode (116) sur un substrat (110) ayant une zone d'éclairage (EA), des première et deuxième zones périphériques (NA1, NA2), et des première et deuxième zones de contact (CA1, CA2) ;
former une première couche de passivation (115a) sur le substrat (110) où la première électrode (116) est formée ;
former une couche organique émissive (130), une deuxième électrode (126) et une deuxième couche de passivation (115b) sur toute la surface du substrat (110), y compris la première couche de passivation (115a) ;
former une tranchée (T) dans les zones périphériques (NA1, NA2) tout autour du périmètre extérieur de la zone d'éclairage (EA) en enlevant la couche organique émissive (130), la deuxième électrode (126) et la deuxième couche de passivation (115b) du périmètre extérieur de la zone d'éclairage (EA), la tranchée (T) séparant la couche organique émissive (130) dans la zone d'éclairage (EA) de la couche organique émissive (130) à l'extérieur de la zone d'éclairage (EA) ; et
fixer un film métallique (170) sur la deuxième couche de passivation (115b) dans la zone d'éclairage (EA) et les première et deuxième zones périphériques (NA1, NA2), avec un adhésif (118) entre eux.

10. Procédé selon la revendication 9, dans lequel la première électrode (116) est formée dans la zone d'éclairage (EA), les première et deuxième zones périphériques (NA1, NA2) et la première zone de contact (CA1) du substrat (110).

11. Procédé selon la revendication 9 ou 10, dans lequel la première couche de passivation (115a) est formée dans la zone d'éclairage (EA) et les première et deuxième zones périphériques (NA1, NA2) du substrat (110), où la première électrode (116) et la deuxième zone de contact du substrat (110) sont formées.

12. Procédé selon l'une quelconque des revendications 9 à 11, dans lequel la tranchée (T) expose une partie de la première couche de passivation (115a) en enlevant des parties de la couche organique émissive (130), de la deuxième électrode (126) et de la deuxième couche de passivation (115b) des première et deuxième zones périphériques (NA1, NA2) du substrat (110) par ablation laser.

13. Procédé selon la revendication 12, dans lequel la couche adhésive (117) est disposée dans la tranchée (T) qui est formée en enlevant les parties de la couche organique émissive (130), de la deuxième électrode (126) et de la deuxième couche de passivation (115b).

14. Procédé selon l'une quelconque des revendications 9 à 13, comprenant en outre, lors de la formation de la tranchée (T), l'étape de former simultanément des premier et deuxième trous de contact (114a, 114b) exposant la première électrode (116) et la première couche de passivation (115a) en enlevant la couche organique émissive (130), la deuxième électrode (126) et la deuxième couche de passivation (115b) des première et deuxième zones de contact (CA1, CA2) du substrat (110) .

15. Procédé selon la revendication 14, comprenant en outre l'étape de former des première et deuxième électrodes de contact (127, 128) dans les première et deuxième zones de contact (CA1, CA2) du substrat (110), les première et deuxième électrodes de contact (127, 128) étant connectées électriquement aux première et deuxième électrodes (116, 126) via les premier et deuxième trous de contact (114a, 114b) après la formation des premier et deuxième trous de contact (114a, 114b).
